# FASCICULE DE BREVET EUROPEEN

(11) **EP 4 020 000 B1**
(45) Date de publication et mention de la délivrance du brevet: **10.07.2024**
(21) Numéro de dépôt: 21306865.3
(22) Date de dépôt: 21.12.2021
(51) Int. Cl.: H01P 7/06, H03K 3/45

(54) **DISPOSITIF COMPRENANT AU MOINS UNE CAVITÉ DE FOCALISATION ÉLECTROMAGNÉTIQUE**
VORRICHTUNG MIT MINDESTENS EINEM ELEKTROMAGNETISCHEN FOKUSSIERUNGSHOHLRAUM
DEVICE COMPRISING AT LEAST ONE ELECTROMAGNETIC FOCUSING CAVITY

(30) Priorité: 22.12.2020 FR 2013884
(43) Date de publication de la demande: 29.06.2022
(73) Titulaire: THALES, 92400 Courbevoie (FR)
(72) Inventeur: VALLON, Henri, 92622 GENNEVILLIERS CEDEX (FR); CAREL, Christian, 92622 GENNEVILLIERS CEDEX (FR); KASSAB, Quentin, 92622 GENNEVILLIERS CEDEX (FR)
(74) Mandataire: Lavoix

(56) Documents cités:
- EP-A1- 3 038 210
- KR-A- 20190 143 704
- RONGGUO ZHOU ET AL: "A compact water based dielectric resonator antenna", ANTENNAS AND PROPAGATION SOCIETY INTERNATIONAL SYMPOSIUM, 2009. APSURSI '09. IEEE, IEEE, PISCATAWAY, NJ, USA, 1 June 2009 (2009-06-01), pages 1 - 4, XP031536110, ISBN: 978-1-4244-3647-7

## Description

La présente invention concerne un dispositif du type comprenant :
- au moins une cavité de focalisation électromagnétique, la cavité ayant une paroi définissant un volume intérieur,
- au moins une antenne émettrice adaptée pour émettre une onde électromagnétique dans le volume intérieur à partir d'un signal électrique d'entrée, la cavité étant destinée à produire par réverbération, à partir de l'onde électromagnétique émise, une onde électromagnétique focalisée dans une zone de focalisation située dans le volume intérieur,
- au moins une entrée pour recevoir le signal électrique d'entrée, l'entrée étant électriquement reliée à l'antenne émettrice,
- au moins une antenne réceptrice adaptée pour recevoir, dans la zone de focalisation, l'onde électromagnétique focalisée, et pour produire un signal électrique de sortie amplifié à partir de l'onde électromagnétique focalisée, et
- au moins une sortie pour recevoir le signal électrique de sortie, la sortie étant électriquement reliée à l'antenne réceptrice.

L'invention concerne aussi un procédé correspondant, mettant en oeuvre un tel dispositif.

La cavité de focalisation électromagnétique est une cavité réverbérant présentant des propriétés ergodiques vis-à-vis de la propagation des ondes électromagnétiques dans le volume intérieur. Une telle cavité est également parfois appelée « cavité chaotique ».

Une application connue d'une telle cavité de focalisation électromagnétique est la génération, à l'extérieure de la cavité, d'une onde électromagnétique de moyenne et de forte puissance, supérieure à quelques kW (kilowatt). L'onde électromagnétique externe est émise par à une antenne recevant le signal électrique en sortie du dispositif.

Les documents FR-A-2 985 385 et FR-A-2 985 386 décrivent par exemple la génération d'ondes électromagnétiques de fortes puissances sur une large bande de fréquences à l'aide de telles cavités.

Pour obtenir une onde particulièrement puissante, il est connu d'appliquer à l'entrée du dispositif un signal électrique d'entrée particulier, obtenu de la manière suivante.

Dans une phase d'apprentissage, un signal électrique impulsionnel (bref) est appliqué en sortie du dispositif. L'antenne réceptrice, agissant alors comme un émetteur, transforme cette impulsion électrique en une onde électromagnétique impulsionnelle qui se propage en se réverbérant dans le volume intérieur. L'onde électromagnétique résultante est captée par les antennes émettrices, agissant alors comme récepteurs, et les signaux électriques sont recueillis à la sortie, par exemple grâce à un oscilloscope. Ces signaux électriques forment une réponse impulsionnelle (réponse à une impulsion) de la cavité entre la sortie et l'entrée. Cette réponse impulsionnelle est étalée dans le temps du fait de la réverbération de l'onde électromagnétique dans le volume intérieur. Cette phase d'apprentissage peut aussi se faire dans le domaine fréquentielle en balayant une plage de fréquence et ensuite utiliser un transformée de Fourier inverse pour obtenir la réponse de la cavité.

A l'intérieur de la cavité, il est en outre connu de mettre en oeuvre plusieurs antennes émettrices.

De plus, du fait des propriétés ergodiques du milieu de propagation, il est possible d'intervertir la ou les antenne(s) d'émission et de réception sans modifier la mesure de la réponse impulsionnelle.

La réponse impulsionnelle est ensuite inversée temporellement, c'est-à-dire qu'elle subit une symétrie temporelle transformant le début du signal en fin du signal, et vice-versa, selon un procédé connu en lui-même. La réponse impulsionnelle inversée est ensuite amplifiée pour former le signal électrique d'entrée. Ce signal peut aussi suivre un traitement afin d'augmenter l'amplification globale du système (par exemple en n'utilisant que la phase du signal). De plus, les différents signaux peuvent suivre des traitements différents, afin par exemple d'augmenter la puissance en sortie dans une direction donnée.

Ce signal électrique d'entrée est transformé en onde électromagnétique dans le volume intérieur par l'antenne émettrice. L'onde électromagnétique après propagation et réverbération sur les parois de la cavité se concentre dans la zone de focalisation pour reformer une onde de type impulsionnel, qui est captée par l'antenne réceptrice et convertie en un signal électrique de sortie très bref et très puissant.

Toutefois, afin de permettre la réverbération de toutes les composantes fréquentielles souhaitées dans les signaux impulsionnels, y compris celles ayant les fréquences les plus basses, le volume intérieur de la cavité est relativement important, de l'ordre d'un mètre-cube. En effet, si les dimensions de la cavité étaient plus faibles, les fréquences les plus basses ne se retrouveraient pas dans le signal électrique de sortie, ou en tous cas pas à la puissance souhaitée. Du fait de ses dimensions, la cavité est donc difficilement transportable, et difficilement intégrable à véhicule tel qu'un drone.

Le document KR 2019 0143704 A décrit une cavité électromagnétique utilisant le principe du renversement temporel afin de générer une impulsion de forte puissance.

L'article de RONGGUO ZHOU et al. "A compact water based dielectric resonator antenna", ANTENNAS AND PROPAGATION SOCIETY INTERNATIONAL SYMPOSIUM, 2009. APSURSI' 09. IEEE, IEEE, PISCATAWAY, NJ, USA, 1er juin 2009, pages 1-4, XP031536110, ISBN 978-1-4244-3647-7, décrit une antenne à résonateur diélectrique compact.

EP 3 038 210 A1 décrit un émetteur d'ondes électromagnétiques comprenant une cavité réverbérante.

Un but de l'invention est donc de fournir un dispositif adapté pour fournir un signal électrique de sortie transformable en une onde électromagnétique de forte puissance, et qui soit moins encombrant que les cavités réverbérantes existantes.

À cet effet, l'invention a pour objet un dispositif selon la revendication 1.

Suivant des modes particuliers de réalisation, le dispositif comprend l'une ou plusieurs des caractéristiques correspondant aux revendications 2 à 9, prise(s) isolément ou selon toutes les combinaisons techniquement possibles.

L'invention a aussi pour objet un véhicule, notamment un drone terrestre ou aérien ou un véhicule mobile, comprenant un moins un dispositif tel que décrit ci-dessus.

L'invention concerne également un procédé selon la revendication 10.

Suivant un mode particulier de réalisation du procédé, le procédé comprend en outre les caractéristiques correspondant à la revendication 11.

L'invention sera mieux comprise à la lecture de la description qui va suivre, donnée uniquement à titre d'exemple, et faite, en se référant aux dessins annexés, sur parmi lesquels :
- la figure 1 est une représentation schématique d'un dispositif selon l'invention,

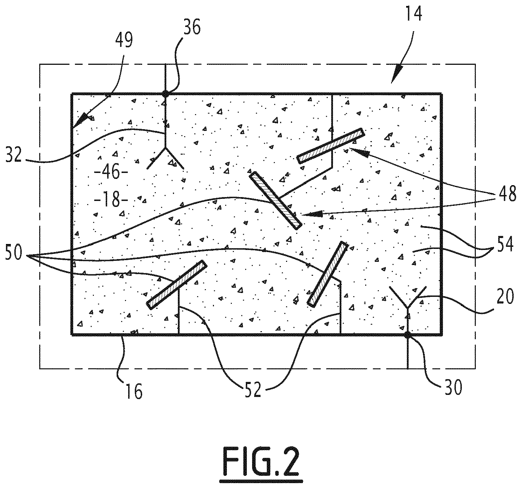

- la figure 2 est une représentation schématique de la cavité représentée sur la figure 1, et
- la figure 3 est une représentation schématique d'une cavité constituant une variante de la cavité représentée sur les figures 1 et 2.

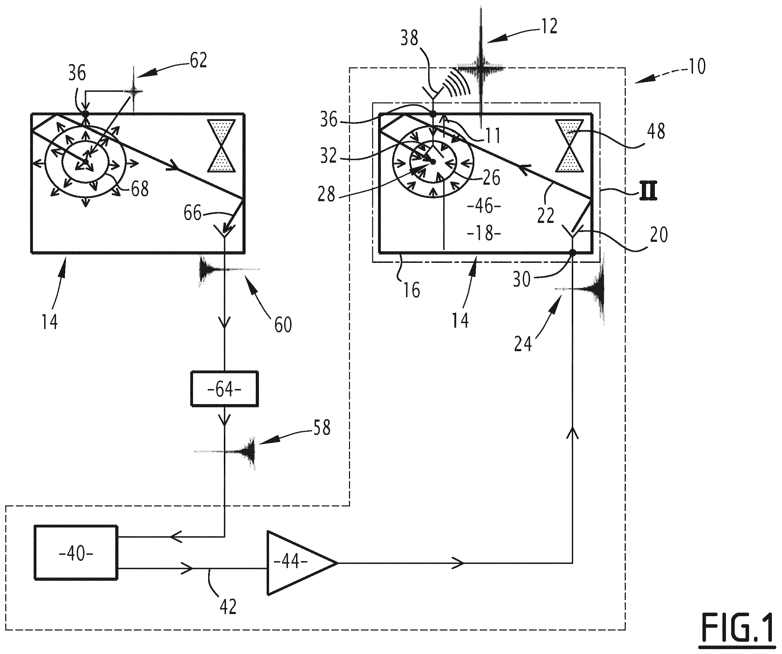

En référence à la figure 1, on décrit un dispositif 10 selon l'invention.

Le dispositif 10 est adapté pour produire un signal électrique de sortie 11 transformable en une onde électromagnétique 12 de forte puissance, par exemple supérieure à quelques kW. Le dispositif 10 est par exemple embarqué à bord d'un véhicule ou une plate-forme (non représentés), tels qu'un drone ou un véhicule mobile.

Le dispositif 10 comprend au moins une cavité 14 de focalisation électromagnétique, la cavité ayant une paroi 16 définissant un volume intérieur 18.

Le dispositif 10 comprend au moins une antenne émettrice 20 adaptée pour émettre une onde électromagnétique 22 dans le volume intérieur 18 à partir d'un signal électrique d'entrée 24, la cavité étant destinée à produire par réverbération, à partir de l'onde électromagnétique 22 émise, une onde électromagnétique focalisée 26 dans une zone de focalisation 28 située dans le volume intérieur 18.

Le dispositif 10 comprend au moins une entrée 30 pour recevoir le signal électrique d'entrée 24, l'entrée 30 étant électriquement reliée à l'antenne émettrice 20.

Le dispositif 10 comprend au moins une antenne réceptrice 32 adaptée pour recevoir, dans la zone de focalisation 28, l'onde électromagnétique focalisée 26, et pour produire, à partir de l'onde électromagnétique focalisée 26, le signal électrique de sortie 11 amplifié.

Selon des variantes non représentées, le dispositif 10 comprend plusieurs antennes émettrices 20 et/ou plusieurs antennes réceptrices 32.

Le dispositif 10 comprend au moins une sortie 36 pour recevoir le signal électrique de sortie 11, la sortie 36 étant électriquement reliée à l'antenne réceptrice 32.

Avantageusement, le dispositif 10 comprend aussi au moins une antenne émettrice 38 externe reliée électriquement à la sortie 36 pour produire l'onde électromagnétique 12 à partir du signal électrique de sortie 11.

En variante, le signal électrique de sortie 11 est envoyé dans un conduit (non représenté).

Avantageusement, le dispositif 10 comprend aussi un générateur 40 de forme d'onde arbitraire adapté pour générer un signal électrique source 42, et un amplificateur 44 pour produire le signal électrique d'entrée 24 à partir du signal électrique source.

Dans les variantes ayant plusieurs antennes émettrices 20, les signaux reçus par ces antennes font avantageusement l'objet d'un traitement différencié, par exemple en déphasage, ce traitement rendant les signaux distincts les uns des autres.

L'amplificateur 44 a par exemple un gain de l'ordre de la dizaine dB.

Le volume intérieur 18 a un volume inférieur à 1,0 m³, de préférence inférieur à 100 dm³, et de manière encore plus préférée inférieur à 10 dm³. Par exemple, le volume est de l'ordre de 1 dm³.

La cavité 14 comprend au moins un matériau diélectrique 46 occupant au moins 70% du volume intérieur 18. La cavité 14 comprend avantageusement des brasseurs 48, symbolisés par deux triangles opposés par la pointe sur la figure 1.

La paroi 16 est par exemple parallélépipédique.

Selon une variante non représentée, la paroi 16 est ellipsoïdale.

La paroi 16 est par exemple en métal et définit une surface interne 49 lisse adaptée pour réfléchir l'onde électromagnétique 22.

Les brasseurs 48 peuvent être de différentes formes et dimensions et sont adaptés pour rendre la cavité 14 ergodique, de manière connue en soi. Les brasseurs 48 comprennent par exemple des plaques métalliques 50 disséminées dans le volume intérieur 18, et avantageusement fixées à la paroi 16 par des supports 52.

Les plaques métalliques 50, et/ou la paroi 16, sont par exemple en aluminium, en cuivre ou en argent.

Le matériau diélectrique 46 occupe au moins 70% du volume intérieur 18. Dans l'exemple représenté, le matériau diélectrique 46 occupe tout le volume intérieur 18, à l'exception de la portion de volume occupée par l'antenne émettrice 20, les brasseurs 48, et l'antenne réceptrice 32.

Le matériau diélectrique 46 possède une permittivité relative complexe εᵣ.

La permittivité relative est sans unité, car elle relie la permittivité du matériau diélectrique à la permittivité du vide : ε = εᵣ.ε₀, ε₀ étant la permittivité du vide.

La permittivité complexe εᵣ a une partie réelle εᵣ' et une partie imaginaire εᵣ" qui peuvent varier selon la fréquence de l'onde électromagnétique considérée:
εᵣ (f) = εᵣ'(f) - iεᵣ"(f), i étant le nombre imaginaire dont le carré vaut -1, et f étant la fréquence de l'onde électromagnétique.

La partie imaginaire εᵣ" est représentative de l'atténuation des ondes électromagnétique dans le matériau 46.

Le matériau diélectrique 46 est choisi pour que la partie réelle εᵣ'(f1), mesurée à une fréquence f1 de 1 GHz, à une température de 25°C et sous une pression de 101325 Pa, soit comprise entre 20 et 65, et que la partie imaginaire εᵣ"(f1), dans les mêmes conditions, soit inférieure à 1/2000.

Il a été constaté que, si la partie réelle est supérieure à 65, la transmission de l'énergie dans la cavité 14 se fait mal, et un échauffement se produisant éventuellement au niveau de certaines jonctions avec le matériau diélectrique 46. Si la partie réelle est inférieure à 20, la cavité 14 ne focalise pas bien les composantes ayant les fréquences les plus basses, toutes choses égales par ailleurs.

L'homme du métier sait mesurer la permittivité d'un matériau ou l'obtenir par des tables. Une méthode de mesure connue consiste à utiliser une ligne de transmission comportant un porte échantillon. Une onde se propage dans la ligne de transmission comportant le porte échantillon et on déduit les propriétés diélectriques (parties réelle et imaginaire) de liquides ou de solides à partir des valeurs de transmissions et de réflexions sur de larges bandes de fréquences. Par ailleurs, dans le cas de faibles pertes, il est possible d'utiliser des mesures complémentaires à différents points de fréquences utilisant une cavité résonnante afin de déterminer la partie imaginaire de la permittivité relative.

Avantageusement, le matériau diélectrique 46 est choisi pour que la partie réelle εᵣ'(f1) précitée et la partie réelle εᵣ'(f2) mesurée à une fréquence f2 de 1 MHz, à une température de 25°C et sous une pression de 101325 Pa diffèrent de moins de 5 en valeur absolue, et pour que la partie imaginaire εᵣ"(f1) précitée et la partie imaginaire εᵣ"(f2) mesurée à la fréquence f2 dans les mêmes conditions de température et de pression diffèrent de moins de 1/5000 en valeur absolue.

Avantageusement, le matériau diélectrique 46 comprend au moins une céramique, par exemple du dioxyde de titane, ou de la zircone stabilisée à l'yttrium (i.e. un mélange de ZrO₂ et YO₂, également connu sous l'acronyme anglais « YSZ »).

Par exemple, le matériau diélectrique 46 comprend au moins 30% en masse de dioxyde de titane, ou au moins 70% en masse de YSZ, le complément étant par exemple un polymère.

Selon un cas particulier, le matériau diélectrique 46 est constitué de YSZ.

Le matériau diélectrique 46 est par exemple en poudre ou sous forme frittée.

Les particules 54 de la poudre ont avantageusement un diamètre hydraulique inférieur à 400 µm, le diamètre hydraulique étant défini comme le diamètre d'une boule ayant le même volume que la particule.

Les supports 52 assurent que les plaques métalliques 50 restent dans une configuration stable par rapport à la paroi 16.

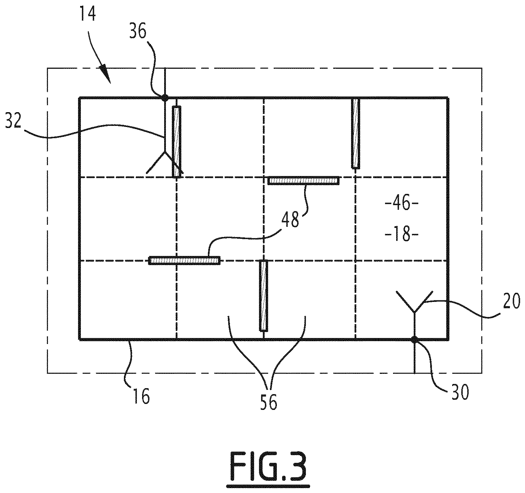

Selon une variante représentée sur la figure 3, le matériau diélectrique 46 se présente sous la forme de briques 56 avantageusement adjacentes les unes aux autres.

Les plaques métalliques 50 sont par exemple maintenues entre les briques 56, ou entre les briques 56 et la paroi 16. Dans cette variante, les supports 52 sont avantageusement absents.

En variante, on conserve les supports 52, afin d'éviter que des vibrations de la cavité 14 ne déplacent les plaques métalliques 50.

Selon une autre variante encore (non strictement représentée), le matériau diélectrique 46 est liquide à 25°C et à une pression de 101325 Pa. Par exemple, le matériau diélectrique 46 comprend de l'eau distillée, et est avantageusement constitué d'eau distillée.

Avantageusement, le signal électrique source 42 a une forme correspondant à un retournement dans le temps 58 d'une réponse impulsionnelle de la cavité 14, la réponse impulsionnelle étant un signal électrique 60 recueilli à l'entrée 30 après qu'un signal électrique impulsionnel 62 a été appliqué à la sortie 36 de la cavité. Un tel signal électrique source 42, une fois amplifié et appliqué à l'entrée 30 a une forme adaptée pour que le signal électrique de sortie 38 soit très bref et puissant.

Selon un mode particulier de réalisation, le signal impulsionnel 62 résulte de la réception d'une onde électromagnétique impulsionnelle (non représentée) par l'antenne émettrice 38 agissant comme un récepteur.

Selon une variante, le signal électrique source 42 est obtenu en le lisant dans une mémoire (non représentée) du générateur 40. Dit autrement, la forme du signal électrique source 42 est préenregistrée.

Selon une autre variante, le signal électrique source 42 est obtenu par analyse fréquentielle, et est la somme de signaux retournés dans le temps, chacun des signaux étant recueilli à l'entrée 30 après qu'un signal harmonique (à une fréquence donnée) a été appliqué à la sortie 36.

Le fonctionnement du dispositif 10 va maintenant être décrit. Ce fonctionnement illustre un procédé selon l'invention, avec avantageusement des étapes de calibration fournissant le signal électrique source 42.

Le signal électrique d'entrée 24 est reçu par l'entrée 30 du dispositif 10. A partir du signal électrique d'entrée 24, l'antenne émettrice 20 émet l'onde électromagnétique 22 dans le volume intérieur 18. A partir de l'onde électromagnétique 22, la cavité 14 produit, par réverbération, l'onde électromagnétique focalisée 26. L'antenne réceptrice 32 reçoit l'onde électromagnétique focalisée 26 et produit, à partir de l'onde électromagnétique focalisée, le signal électrique de sortie 11. La sortie 36 reçoit le signal électrique de sortie.

Avantageusement, le signal électrique de sortie 11 est reçu par l'antenne émettrice 38 et l'onde électromagnétique 12 est émise.

Le signal électrique d'entrée 24 est par exemple produit par une amplification du signal électrique source 42 par l'amplificateur 44, le signal électrique source étant généré par le générateur 40.

Le signal électrique source 42 est avantageusement obtenu par une calibration (figure 1 en haut à gauche) de la cavité 14. Pour ce faire, le signal électrique impulsionnel 62 est appliqué à la sortie 36 du dispositif. Le signal électrique 60, à l'entrée 30 du dispositif, est enregistré, par exemple par un oscilloscope 64 pour obtenir la réponse impulsionnelle de la cavité 14. La réponse impulsionnelle est retournée temporellement, par exemple par l'oscilloscope 64, le générateur 40, ou un calculateur (non représenté), pour obtenir la réponse impulsionnelle 58 retournée dans le temps. La réponse impulsionnelle 58 retournée dans le temps fournit la forme du signal électrique source 42 généré par le générateur 40.

Le signal électrique 60 est produit par l'antenne émettrice 20, agissant comme un récepteur, qui capte une onde électromagnétique 66 résultant de la réverbération par la cavité 14 d'une onde électromagnétique 68 émise par l'antenne réceptrice 32, agissant comme un émetteur, à partir du signal électrique impulsionnel 62.

De la même façon que l'onde électromagnétique focalisée 26 résulte d'une « compression » de l'onde électromagnétique 22 par la cavité 14, l'onde électromagnétique 66 résulte d'un « allongement » (une diffusion) de l'onde électromagnétique 68 par la cavité.

Grâce aux caractéristiques décrites ci-dessus, le dispositif 10 est adapté pour fournir un signal électrique de sortie 11 transformable en une onde électromagnétique 12 de forte puissance. Le dispositif 10 est moins encombrant que les cavités réverbérantes existantes grâce à la permittivité relative particulière du matériau diélectrique 46.

## Revendications

1. Dispositif (10) comprenant :
- au moins une cavité (14) de focalisation électromagnétique, la cavité (14) ayant une paroi (16) définissant un volume intérieur (18),
- au moins une antenne émettrice (20) adaptée pour émettre une onde électromagnétique (22) dans le volume intérieur (18) à partir d'un signal électrique d'entrée (24), la cavité (14) étant destinée à produire par réverbération, à partir de l'onde électromagnétique (22) émise, une onde électromagnétique focalisée (26) dans une zone de focalisation (28) située dans le volume intérieur (18),
- au moins une entrée (30) pour recevoir le signal électrique d'entrée (24), l'entrée (30) étant électriquement reliée à l'antenne émettrice (20),
- au moins une antenne réceptrice (32) adaptée pour recevoir, dans la zone de focalisation (28), l'onde électromagnétique focalisée (26), et pour produire un signal électrique de sortie (11) amplifié à partir de l'onde électromagnétique focalisée (26), et
- au moins une sortie (36) pour recevoir le signal électrique de sortie (11), la sortie (36) étant électriquement reliée à l'antenne réceptrice (32),
- le volume intérieur (18) a un volume inférieur à 1,0 m³, et
- la cavité (14) comprend au moins un matériau diélectrique (46) occupant au moins 70% du volume intérieur (18), le matériau diélectrique (46) possédant une permittivité relative complexe, la permittivité complexe ayant une partie réelle et une partie imaginaire, **caractérisé en ce que**
la partie réelle mesurée à 1 GHz étant comprise entre 20 et 65, et la partie imaginaire mesurée à 1 GHz étant inférieure à 1/2000.

2. Dispositif (10) selon la revendication 1, dans lequel :
- la partie réelle mesurée à 1 GHz et la partie réelle mesurée à 1 MHz diffèrent de moins de 5 en valeur absolue, et
- la partie imaginaire mesurée à 1 GHz et la partie imaginaire mesurée à 1 MHz diffèrent de moins de 1/5000 en valeur absolue.

3. Dispositif (10) selon la revendication 1 ou 2, dans lequel le matériau diélectrique est liquide à 25°C et à une pression de 101325 Pa.

4. Dispositif (10) selon l'une quelconque des revendications 1 à 3, dans lequel le matériau diélectrique (46) comprend un liquide, notamment de l'eau distillée.

5. Dispositif (10) selon la revendication 1 ou 2, dans lequel le matériau diélectrique (46) comprend au moins 30% en masse de dioxyde de titane, ou au moins 70% en masse de zircone stabilisée à l'yttrium.

6. Dispositif (10) selon la revendication 5, dans lequel le matériau diélectrique (46) est poudreux, ou sous forme de briques (56) adjacentes les unes aux autres.

7. Dispositif (10) selon l'une quelconque des revendications 1, 2 et 5, dans lequel la cavité (14) comprend des brasseurs (48) adaptés pour rendre la cavité (14) ergodique et comprenant des plaques métalliques (50) disséminées dans le volume intérieur (18), le matériau diélectrique (46) se présentant sous la forme de briques (56) adjacentes les unes aux autres, les plaques métalliques (50) étant maintenues entre les briques (56), ou entre les briques (56) et la paroi (16).

8. Dispositif (10) selon l'une quelconque des revendications 1 à 7, comprenant en outre :
- un générateur (40) de forme d'onde arbitraire adapté pour générer un signal électrique source (42), et
- un amplificateur (44) pour produire le signal électrique d'entrée (24) à partir du signal électrique source (42).

9. Dispositif (10) selon la revendication 8, dans lequel le signal électrique source (42) a une forme correspondant à un retournement dans le temps d'une réponse impulsionnelle de la cavité, la réponse impulsionnelle étant un signal électrique (60) recueilli à l'entrée (30) du dispositif (10) après qu'un signal électrique impulsionnel (62) a été appliqué à la sortie (36) du dispositif (10).

10. Procédé comprenant les étapes suivantes :
- obtention d'un dispositif (10) selon l'une quelconque des revendications 1 à 9,
- réception, par l'entrée (30) du dispositif (10), du signal électrique d'entrée (24),
- émission par l'antenne émettrice (20) de l'onde électromagnétique (22) dans le volume intérieur (18) à partir du signal électrique d'entrée (24),
- production par la cavité (14), par réverbération, à partir de l'onde électromagnétique (22) émise, de l'onde électromagnétique focalisée (26),
- réception, par l'antenne réceptrice (32), de l'onde électromagnétique focalisée (26), et production, à partir de l'onde électromagnétique focalisée (26), du signal électrique de sortie (11) amplifié, et
- réception, par la sortie (36) du dispositif (10), du signal électrique de sortie (11).

11. Procédé selon la revendication 10, dans lequel le dispositif (10) obtenu est selon la revendication 9, et comprenant en outre les étapes suivantes :
- application du signal électrique impulsionnel (62) à la sortie (32) du dispositif (10),
- enregistrement du signal électrique (60) à l'entrée (30) du dispositif (10), pour obtenir la réponse impulsionnelle de la cavité (14), et
- retournement temporel de la réponse impulsionnelle et obtention d'une réponse impulsionnelle (58) retournée dans le temps.

## Patentansprüche

1. Vorrichtung (10) umfassend:
- mindestens einen Hohlraum (14) zur elektromagnetischen Fokussierung, wobei der Hohlraum (14) eine Wand (16) aufweist, die ein Innenvolumen (18) definiert,
- mindestens eine Sendeantenne (20), die so beschaffen ist, dass sie ausgehend von einem elektrischen Eingangssignal (24) eine elektromagnetische Welle (22) in das Innenvolumen (18) aussendet, wobei der Hohlraum (14) dazu bestimmt ist, durch Nachhall aus der gesendeten elektromagnetischen Welle (22) eine fokussierte elektromagnetische Welle (26) in einem Fokussierungsbereich (28) zu erzeugen, der sich in dem Innenvolumen (18) befindet,
- mindestens einen Eingang (30) zum Empfangen des elektrischen Eingangssignals (24), wobei der Eingang (30) elektrisch mit der Sendeantenne (20) verbunden ist,
- mindestens eine Empfangsantenne (32), die so beschaffen ist, dass sie in der Fokussierungszone (28) die fokussierte elektromagnetische Welle (26) empfängt und aus der fokussierten elektromagnetischen Welle (26) ein verstärktes elektrisches Ausgangssignal (11) erzeugt, und
- mindestens einen Ausgang (36) zum Empfangen des elektrischen Ausgangssignals (11), wobei der Ausgang (36) elektrisch mit der Empfangsantenne (32) verbunden ist,
- das Innenvolumen (18) ein Volumen von weniger als 1,0 m³ hat und
- der Hohlraum (14) mindestens ein dielektrisches Material (46) umfasst, das mindestens 70% des Innenvolumens (18) einnimmt, wobei das dielektrische Material (46) eine komplexe relative Permittivität aufweist, wobei die komplexe Permittivität einen Realteil und einen Imaginärteil hat, **dadurch gekennzeichnet, dass** der Realteil, gemessen bei 1 GHz, zwischen 20 und 65 liegt, und der Imaginärteil, gemessen bei 1 GHz, weniger als 1/2000 beträgt.

2. Vorrichtung (10) nach Anspruch 1, wobei:
- der bei 1 GHz gemessene Realteil und der bei 1 MHz gemessene Realteil sich um weniger als 5 als Absolutwert unterscheiden und
- der bei 1 GHz gemessene Imaginärteil und der bei 1 MHz gemessene Imaginärteil sich um weniger als 1/5000 als Absolutwert unterscheiden.

3. Vorrichtung (10) nach Anspruch 1 oder 2, wobei das dielektrische Material bei 25 °C und einem Druck von 101.325 Pa flüssig ist.

4. Vorrichtung (10) nach einem der Ansprüche 1 bis 3, wobei das dielektrische Material (46) eine Flüssigkeit, insbesondere destilliertes Wasser, umfasst.

5. Vorrichtung (10) nach Anspruch 1 oder 2, wobei das dielektrische Material (46) mindestens 30 Massen-% Titandioxid oder mindestens 70 Massen-% Yttrium-stabilisiertes Zirkoniumdioxid umfasst.

6. Vorrichtung (10) nach Anspruch 5, wobei das dielektrische Material (46) pulverförmig ist oder in Form von aneinandergrenzenden Steinen (56) vorliegt.

7. Vorrichtung (10) nach einem der Ansprüche 1, 2 und 5, wobei der Hohlraum (14) Düsen (48) aufweist, die dazu geeignet sind, den Hohlraum (14) ergodisch zu gestalten, und Metallplatten (50) aufweist, die in dem Innenvolumen (18) verteilt sind, wobei das dielektrische Material (46) in Form von aneinandergrenzenden Steinen (56) vorliegt und die Metallplatten (50) zwischen den Steinen (56) oder zwischen den Steinen (56) und der Wand (16) gehalten werden.

8. Vorrichtung (10) nach einem der vorherigen Ansprüche 1 bis 7, ferner umfassend:
- einen Generator (40) für beliebige Wellenformen, der so beschaffen ist, dass er ein elektrisches Quellsignal (42) erzeugt, und
- einen Verstärker (44), um das elektrische Eingangssignal (24) aus dem elektrischen Quellsignal (42) zu erzeugen.

9. Vorrichtung (10) nach Anspruch 8, bei der das elektrische Quellsignal (42) eine Form hat, die einer zeitlichen Umkehrung einer Impulsantwort des Hohlraums entspricht, wobei die Impulsantwort ein elektrisches Signal (60) ist, das am Eingang (30) der Vorrichtung (10) gesammelt wird, nachdem ein elektrisches Impulssignal (62) an den Ausgang (36) der Vorrichtung (10) angelegt wurde.

10. Verfahren, das die folgenden Schritte umfasst:
- Erlangen einer Vorrichtung (10) nach einem der Ansprüche 1 bis 9,
- Empfangen des elektrischen Eingangssignals (24) durch den Eingang (30) der Vorrichtung (10),
- Senden der elektromagnetischen Welle (22) durch die Sendeantenne (20) in das Innenvolumen (18) aus dem elektrischen Eingangssignal (24),
- Erzeugung der fokussierten elektromagnetischen Welle (26) durch den Hohlraum (14) durch Nachhall aus der ausgestrahlten elektromagnetischen Welle (22),
- Empfangen der fokussierten elektromagnetischen Welle (26) durch die Empfangsantenne (32) und Erzeugen des verstärkten elektrischen Ausgangssignals (11) aus der fokussierten elektromagnetischen Welle (26), und
- Empfangen des elektrischen Ausgangssignals (11) durch den Ausgang (36) der Vorrichtung (10).

11. Verfahren nach Anspruch 10, wobei die erhaltene Vorrichtung (10) nach Anspruch 9 ist, und ferner die folgenden Schritte umfasst:
- Anlegen des elektrischen Impulssignals (62) an den Ausgang (32) der Vorrichtung (10),
- Aufzeichnen des elektrischen Signals (60) am Eingang (30) der Vorrichtung (10), um die Impulsantwort des Hohlraums (14) zu erhalten, und
- zeitliches Umdrehen der Impulsantwort und Erhalten einer zeitlich umgedrehten Impulsantwort (58).

## Claims

1. A device (10) comprising:
- at least one electromagnetic focusing cavity (14), the cavity (14) having a wall (16) defining an internal volume (18),
- at least one transmitting antenna (20) adapted to transmit an electromagnetic wave (22) into the interior volume (18) from an electrical input signal (24), the cavity (14) being designed by reverberation, from the transmitted electromagnetic wave (22), a focused electromagnetic wave (26) in a focusing zone (28) located in the interior volume (18),
- at least one input (30) for receiving the electrical input signal (24), the input (30) being electrically connected to the transmitting antenna (20),
- at least one receiving antenna (32) adapted to receive, in the focusing zone (28), the focused electromagnetic wave (26), and to produce an amplified electrical output signal (11) from the focused electromagnetic wave (26), and
- at least one output (36) for receiving the electrical output signal (11), the output (36) being electrically connected to the receiving antenna (32),
- the internal volume (18) is less than 1.0 m³, and
- the cavity (14) comprises at least one dielectric material (46) occupying at least 70% of the interior volume (18), the dielectric material (46) having a complex relative permittivity, the complex permittivity having a real part and an imaginary part, **characterised in that** the real part measured at 1 GHz being between 20 and 65, and the imaginary part measured at 1 GHz being less than 1/2000.

2. The device (10) according to claim 1, wherein:
- the real part measured at 1 GHz and the real part measured at 1 MHz differ by less than 5 in absolute value, and
- the imaginary part measured at 1 GHz and the imaginary part measured at 1 MHz differ by less than 1/5000 in absolute value.

3. A device (10) according to claim 1 or 2, wherein the dielectric material is liquid at 25 °C and a pressure of 101,325 Pa.

4. A device (10) according to any one of claims 1 to 3, wherein the dielectric material (46) comprises a liquid, in particular distilled water.

5. A device (10) according to claim 1 or 2, wherein the dielectric material (46) comprises at least 30% by mass of titanium dioxide, or at least 70% by mass of yttriastabilised zirconia.

6. A device (10) according to claim 5, in which the dielectric material (46) is powdery, or in the form of bricks (56) adjacent to one another.

7. A device (10) according to any one of claims 1, 2 and 5, wherein the cavity (14) comprises stirrers (48) adapted to render the cavity (14) ergodic and comprising metal plates (50) scattered throughout the interior volume (18), the dielectric material (46) being in the form of bricks (56) adjacent to one another, the metal plates (50) being held between the bricks (56), or between the bricks (56) and the wall (16).

8. A device (10) according to any of claims 1 to 7, also comprising:
- an arbitrary waveform generator (40) adapted to generate an electrical source signal (42), and
- an amplifier (44) for producing the electrical input signal (24) from the electrical source signal (42).

9. A device (10) according to claim 8, wherein the source electrical signal (42) has a shape corresponding to a reversal in time of an impulse response of the cavity, the impulse response being an electrical signal (60) collected at the input (30) of the device (10) after a pulsed electrical signal (62) has been applied to the output (36) of the device (10).

10. A method comprising the following steps:
- obtaining a device (10) according to any one of claims 1 to 9,
- reception, by the input (30) of the device (10), of the electrical input signal (24),
- transmission by the transmitting antenna (20) of the electromagnetic wave (22) into the interior volume (18) from the electrical input signal (24),
- production by the cavity (14), by reverberation, of the focused electromagnetic wave (26) from the emitted electromagnetic wave (22),
- reception, by the receiving antenna (32), of the focused electromagnetic wave (26), and production, from the focused electromagnetic wave (26), of the amplified electrical output signal (11), and
- reception, by the output (36) of the device (10), of the electrical output signal (11).

11. A method as claimed in claim 10, wherein the resulting device (10) is as claimed in claim 9, and further comprising the following steps:
- applying the pulsed electrical signal (62) to the output (32) of the device (10),
- recording of the electrical signal (60) at the input (30) of the device (10), to obtain the impulse response of the cavity (14), and
- time reversal of the impulse response and obtaining a time-reversed impulse response (58).
